# EUROPÄISCHE PATENTSCHRIFT

(11) **EP 2 412 216 B1**
(45) Veröffentlichungstag und Bekanntmachung des Hinweises auf die Patenterteilung: **20.09.2017**
(21) Anmeldenummer: 10708728.0
(22) Anmeldetag: 11.03.2010
(51) Int. Cl.: H05K 7/20, H05K 5/02

(54) **GEHÄUSE**
CASING
BOÎTIER

(30) Priorität: 24.03.2009 DE 102009014148
(43) Veröffentlichungstag der Anmeldung: 01.02.2012
(73) Patentinhaber: SEW-EURODRIVE GmbH & Co. KG, 76646 Bruchsal (DE)
(72) Erfinder: HANNICH, Thomas, 76646 Bruchsal (DE)
(86) Internationale Anmeldenummer: PCT/EP2010/001534
(87) Internationale Veröffentlichungsnummer: WO 2010/108597

(56) Entgegenhaltungen:
- EP-A2- 1 739 362
- DE-A1- 3 242 943
- US-A1- 2003 050 002
- US-A1- 2004 233 654
- US-A1- 2005 017 610

## Beschreibung

Die Erfindung betrifft ein Gehäuse.

Aus der DE 9320825U1 ist ein Gehäuse zur Aufnahme einer mit wärmeerzeugenden Bauelementen versehenen Steuereinrichtung bekannt. Das Gehäuse umfasst einen Deckel und einen Boden wobei der Deckel und der Boden mit Durchbrüchen für die Entwärmung versehen sind. "US 2005/017610 A1" offenbart ein Gehäuse gemäß dem Oberbegriff des Patentanspruchs 1. Der Erfindung liegt die Aufgabe zugrunde, ein Gehäuse weiterzubilden.

Erfindungsgemäß wird die Aufgabe bei der nach den in Anspruch 1 angegebenen Merkmalen gelöst.

Wichtige Merkmale der Erfindung bei dem Gehäuse sind, dass das Gehäuse mindestens eine Gehäusewand umfasst, welche vorzugsweise als Deckel, Rückwand, Frontwand, oder als ein von zwei Seitenwänden ausgeführt ist, wobei in der Gehäusewand ein oder mehrere Teilbereich der Gehäusewand durch jeweils eine zumindest teilweise den Teilbereich oder die mehreren Teilbereiche umlaufende Unterbrechung der Gehäusewand von einem Restbereich der Gehäusewand teilweise getrennt ist, wobei der Teilbereich oder die mehreren Teilbereiche entlang jeweils einer Biegelinie mit dem Restbereich verbunden ist bzw. sind und der Teilbereich oder die mehreren Teilbereiche entlang der jeweiligen Biegelinie so umgebogen ist bzw. sind, dass der Teilbereich aus dem Gehäuse hervorsteht oder in das Gehäuse hineinragt bzw. die mehreren Teilbereiche aus dem Gehäuse hervorstehen oder in das Gehäuse hineinragen. Von Vorteil ist dabei, dass ein Luftdurchsatz durch das Gehäuse erhöht ist.

Bei einer vorteilhaften Ausgestaltung ist das Gehäuse für ein elektrisches Gerät insbesondere einen Umrichter vorgesehen. Von Vorteil ist dabei, dass das elektrische Gerät qualitativ und quantitativ besser entwärmt ist.

Bei einer weiteren vorteilhaften Ausgestaltung sind die mehreren Teilbereiche in Feldern angeordnet. Von Vorteil ist dabei, dass der Luftstrom durch das Gehäuse besser einstellbar ist.

Bei einer weiteren vorteilhaften Ausgestaltung ragen die mehreren Teilbereiche in einem Feld alle in das Gehäuse hinein oder stehen aus dem Gehäuse hervor, insbesondere weisen die Teilbereiche auch eine gleiche geometrische Ausführung auf. Von Vorteil ist dabei, dass der Herstellungsprozesse vereinfacht ist und die Luftströmung durch das Gehäuse verbessert ist.

Bei einer weiteren vorteilhaften Ausgestaltung sind die mehreren Teilbereiche in einem Feld regelmäßig voneinander beabstandet, insbesondere sind die Teilbereiche in zwei Richtungen regelmäßig voneinander beabstandet Von Vorteil ist dabei, dass der Luftstrom durch das Gehäuse verbessert ist.

Bei einer weiteren vorteilhaften Ausgestaltung ist der Teilbereich oder die mehreren Teilbereiche als je eine Ebene um einen Winkel im Bereich zwischen null und neunzig Grad, vorzugsweise zwischen fünf Grad und fünfundvierzig Grad umgebogen. Von Vorteil ist dabei, dass der Luftstrom durch das Gehäuse gezielt beeinflussbar ist.

Bei einer weiteren vorteilhaften Ausgestaltung weisen der Teilbereich oder die mehreren Teilbereiche je eine viereckige, vorzugsweise annähernd quadratische Form auf und die jeweilige Biegelinie entspricht einer Kante der viereckigen Form. Von Vorteil ist dabei, dass die Herstellung vereinfacht ist und der Luststrom durch das Gehäuse einfach einstellbar ist.

Bei einer weiteren vorteilhaften Ausgestaltung ist die Unterbrechung mittels Laserschneiden in die Gehäusewand eingebracht. Von Vorteil ist dabei, dass keine Grate entstehen, welche nachbearbeitet werden müssten oder Verwirbelungen des Luftstroms durch das Gehäuse erzeugen würden. Laserschneiden weist auch eine hohe Flexibilität in der Formgebung der Teilbereiche auf. So lässt sich die Form der Teilbereiche an eine gewünschte Luftleiteigenschaft der Teilbereiche anpassen.

Bei einer weiteren vorteilhaften Ausgestaltung ist die Rückwand des Gehäuses frei von Teilbereichen. Von Vorteil ist dabei, dass ein kontinuierlicher Luftstrom entlang der Rückwand entsteht.

Bei einer weiteren vorteilhaften Ausgestaltung stehen die Teilbereiche im Deckel des Gehäuses aus dem Gehäuse hervor und eine dadurch entstehende Öffnung ist zu der Rückwand des Gehäuses gerichtet, insbesondere wobei eine zur Rückwand gerichtete Kante des Deckels von der Rückwand beabstandet ist, wodurch ein Spalt gebildet ist. Von Vorteil ist dabei, dass entlang der Rückwand ein erhöhter Luftstrom entsteht, welcher die durch die durch die umgebogenen Teilbereiche entstanden Löcher in den Gehäusewänden eingesogen Luft zielgerichteter durch das Gehäuse strömen lässt.

Bei einer weiteren vorteilhaften Ausgestaltung verlaufen die Biegelinien der Teilbereiche des Deckels parallel zur Rückwand. Von Vorteil ist dabei, dass die austretende, erwärmte Luft nach hinten abgelenkt wird und ein verbessertes Arbeiten am bzw. vor dem Gehäuse erlaubt.

Bei einer weiteren vorteilhaften Ausgestaltung entsprechen die Biegelinien in den zwei Seitenwänden und einer Frontwand des Gehäuses der in das Gehäuse ragenden Teilbereiche einer nach unten gerichteten Abgrenzungslinie der in das Gehäuse ragenden Teilbereiche und die Biegelinien der nach aus dem Gehäuse hervorstehende Teilbereiche entsprechen einer nach oben gerichteten Abgrenzungslinie der aus dem Gehäuse hervorstehenden Teilbereiche. Von Vorteil ist dabei, dass ein Luftstrom von unten eingesaugt wird und der Luftstrom durch das Gehäuse von unten nach oben, der Thermik entsprechend, geleitet wird.

Bei einer weiteren vorteilhaften Ausgestaltung ragen in beiden Seitenwänden des Gehäuses alle Teilbereiche in das Gehäuse hinein. Von Vorteil ist dabei, dass zwei Gehäuse mit direktem Kontakt der Seitenwände nebeneinander aufstellbar sind.

Bei einer weiteren vorteilhaften Ausgestaltung ist das Gehäuse nach oben hin verjüngt ausgeführt, insbesondere ein oberer Endabschnitt der Frontwand des im Wesentlichen quaderförmigen Gehäuses in Richtung oben zu der Rückwand des Gehäuses geneigt ist, vorzugsweise ist dabei zwischen dem oberen Endabschnitt und einer Restfläche der Frontwand ein Winkel zwischen null und neunzig Grad gebildet. Von Vorteil ist dabei, dass ein Düseneffekt entsteht.

Bei einer weiteren vorteilhaften Ausgestaltung steht ein Steuerungsteil einer im Gehäuse angeordneten elektrischen Vorrichtung aus dem oberen Abschnitt zumindest teilweise hervor, wobei insbesondere eine Bedienoberfläche des Steuerungsteils parallel zu der Rückwand des Gehäuses ausgerichtet ist. Von Vorteil ist dabei, dass eine empfindliche Elektronik des Steuerungsteils von Wärmequellen im Gehäuse besser thermisch beabstandet ist.

Weitere Vorteile ergeben sich aus den Unteransprüchen.

### Bezugszeichenliste

- 10: Gehäuse
- 12: Deckel
- 14: Seitenwand
- 16: Frontwand
- 18: oberer Abschnitt
- 20: Teilbereich
- 22: Feld
- 24: Unterbrechung
- 26: Restbereich
- 28: Biegelinie
- 29: verbreiteter Schnitt
- 30: Rückwand
- 32: Öffnung
- 34: Spalt
- 40: Steuerungsteil
- 42: Handbediengerät

Die Erfindung wird nun anhand von Ausführungsbeispielen mit Bezugnahme auf die Zeichnung näher erläutert. Es zeigen rein schematisch:
- Fig. 1: eine dreidimensionale Ansicht eines erfindungsgemäßen Gehäuses;
- Fig. 2: eine Detailansicht der in Figur 1 gezeigten Ansicht; und
- Fig. 3: eine weitere Detailansicht des in Figur 1 gezeigten Gehäuses aus einer anderen Blickrichtung.

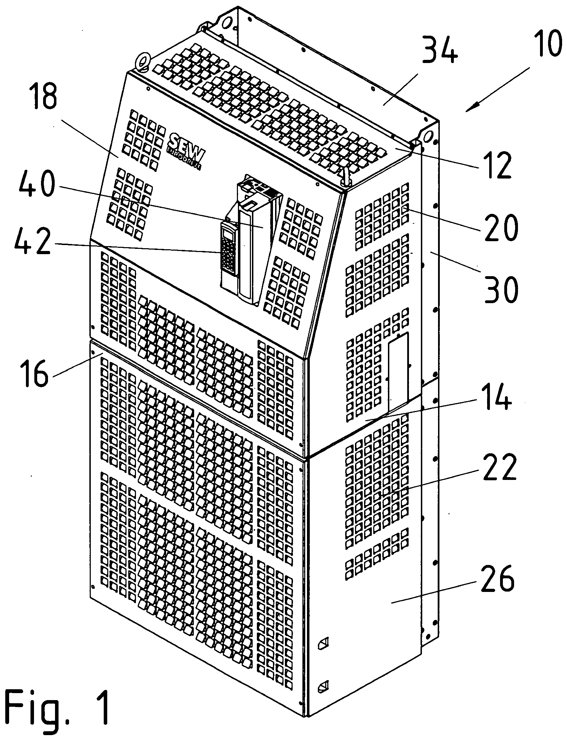

In der Figur 1 ist ein erfindungsgemäßes Gehäuse 10 in einer dreidimensionalen Ansicht gezeigt. Das Gehäuse 10 weist mindestens eine Gehäusewand auf. Vorzugsweise weist das Gehäuse 10 bezogen auf den aufgestellten Zustand als Gehäusewand einen Deckel 12, zwei Seitenwände 14 eine Frontwand 16 und eine Rückwand 30 auf. Bei der in Figur 1 gezeigten Ausführungsform sind die Seitenwände 14 und die Frontwand 16 zweiteilig mit je einem oberen und unteren Teil ausgeführt. Eine Grundform des Gehäuses 10 ist annähernd quaderförmig. Die Gehäusewand umschließt einen Innenbereich und trennt den Innenbereich von einem Außenbereich.

Das Gehäuse 10 ist auf einem nicht gezeigten Sockel befestigbar, welcher vorzugsweise aus Vierkantrohren als Rahmensockel ausgeführt ist.

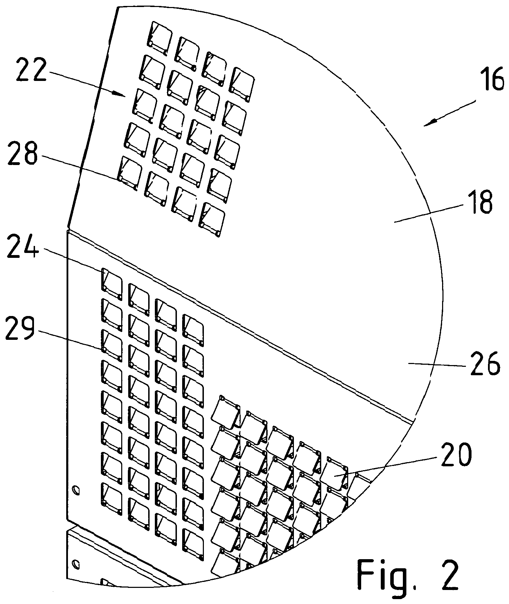

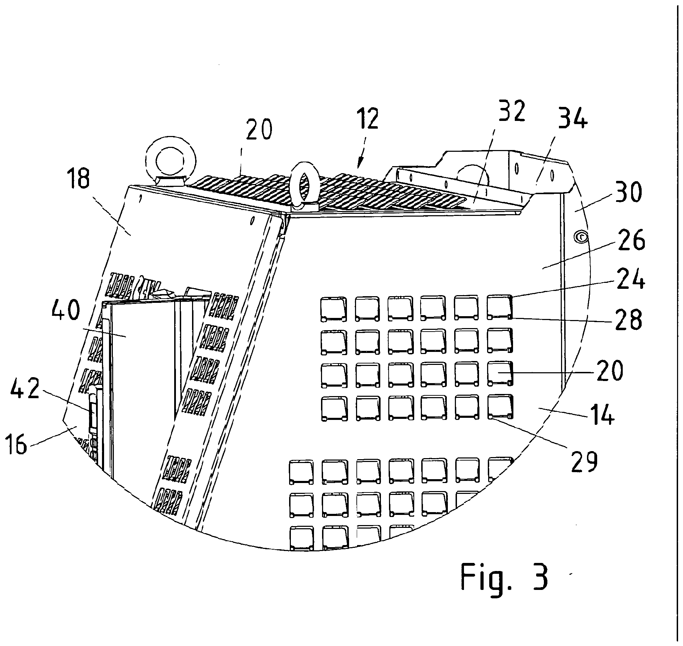

Wie insbesondere in Figur 2 und Figur 3 zu sehen, weist die Gehäusewand einen Teilbereich 20 insbesondere mehrere Teilbereiche 20 auf, welcher annähernd quadratisch geformt ist bzw. sind. Die Ecken des Teilbereiches 20 sind abgerundet. Eine Unterbrechung 24 läuft um drei Seiten des Teilbereiches 20 herum. Die Unterbrechung 24 trennt den Teilbereich 20 von einem Restbereich 26 der Gehäusewand ab. Entlang einer Biegelinie 28 ist der Teilbereich mit dem Restbereich 26 verbunden. Die Biegelinie 28 entspricht im Wesentlichen einer vierten Seite des Teilbereichs 20. Die Unterbrechung 24 verläuft beidseitig in die vierte Seite, entlang welcher die Biegelinie verläuft, hinein. Die Unterbrechung 24 ist als Schnitt durch Laserschneiden oder Stanzen ausgeführt, wobei die Ecken der vierten Seite einen verbreiterten Schnitt 29, als Einschnitte bis zur Biegelinie 18, aufweisen. Somit sind die Gehäusewände als Laserschneid-Biegeteil oder als Stanzbiegeteil ausgeführt. Beim Laserschneiden entstehen gratfreie Kanten, welche einfacher weiterverarbeitet können. Ein Stanzbiegeteil ist bei hohen Stückzahlen kostengünstiger.

Durch den verbreiterten Schnitt 29 lässt sich der Teilbereich 20 leichter entlang der Biegelinie 28 umbiegen. Der umgebogene Teilbereich 20 ragt entweder in das Gehäuse hinein oder steht aus dem Gehäuse hervor. Im gezeigten Ausführungsbeispiel verläuft die Biegung ausschließlich entlang der Biegelinie 28. Der Teilbereich 20 bleibt ansonsten eben und liegt somit entweder im Innenbereich oder im Außenbereich des Gehäuses 10. In weiteren nicht gezeigten Ausführungsbeispielen ist auch ein weiteres Verbiegen des Teilbereiches 20 möglich. Zum Beispiel könnte der Teilbereich 20 so umgebogen sein, das ein freistehender Endabschnitt des Teilbereichs 20 parallel zum Restbereich der Gehäusewand verläuft.

Die mehreren Teilbereiche 20 sind in Feldern 22 angeordnet. Innerhalb eines Feldes 22 sind die Teilbereiche 20 in waagerechter und senkrechter Richtung regelmäßig voneinander beabstandet. Die Teilbereiche 20 in einem Feld 22 sind aneinander ausgerichtet, d.h. dass die Seiten der Teilbereiche 20 in einer Linie fortgeführt sind. Dadurch weisen die Felder 22 ein regelmäßiges Raster auf. Die Grenzen der Felder 22 weisen selber wieder eine viereckige Form auf. Manche Felder 22 stoßen direkt aufeinander. Andere Felder 22 sind voneinander beabstandet, wobei die Grenzen der Felder 22 meist wieder in einer Linie liegen.

In weiteren Ausführungsformen weisen die Felder 22 andere Formen auf, wie zum Beispiel kreisförmig, pyramidenförmig, dreieckförmig, etc.. Auch die Teilbereiche 20 sind mit verschiedenen Formen, wie elliptisch bis kreisförmig, dreieckig etc. ausführbar. So lässt sich ein Luftstrom durch das Gehäuse optimal dimensionieren bzw. der Luftstrom lässt sich durch bestimmte Bereiche des Innenbereiches leiten.

Innerhalb eines Feldes 22 ragen die Teilbereiche 20 entweder alle in das Gehäuse 10 hinein oder stehen aus dem Gehäuse 10 hervor. Bei den Seitenwänden und der Frontwand liegen im aufgestellten Zustand des Gehäuses 10 die Biegelinien 28 für die in das Gehäuse 10 hineinragenden Teilbereiche 20 in der unteren Seite des Teilbereiches 20. Für die aus dem Gehäuse hervorstehenden Teilbereiche 20 liegen die Biegelinien 28 in der oberen Seite des entsprechenden Teilbereiches 20. So kann Luft gut von unten in das Gehäuse 10 hineinströmen. Gleichzeitig wirken die Teilbereiche 20 als Luftleitbleche, an denen ein Luftstrom vorbeigeleitet ist. Der Luftstrom entwärmt auf diese Weise den Innenbereich des Gehäuses 10 effektiver und zielgerichteter. Gleichzeitig strömt die Luft auch besser an den erwärmten Gehäusewänden insbesondere den Teilbereichen 20 vorbei und entwärmt diese effektiver.

Die mehreren Teilbereiche 20 in den Seitenwände 14 ragen vorzugsweise in das Gehäuse hinein. So lassen sich mehrere Gehäuse 10 direkt nebeneinander aufstellen, ohne dass ein Abstand zwischen den Gehäusen 10 eingehalten werden müsste.

Die Teilbereiche 20 im Deckel 12 stehen alle aus dem Gehäuse 10 hervor. Dadurch kann die im Gehäuse 10 erwärmte Luft gut nach oben abziehen. Vorzugsweise ist eine durch die umgebogenen Teilbereiche 20 gebildete Öffnung zur Rückwand 30 gerichtet und die aufsteigende im Gehäuse 10 erwärmte Luft wird in Richtung Rückwand 30 abgelenkt. Dies erlaubt ein entspannteres Arbeiten an bzw. vor dem Gehäuse.

Eine parallel zur Rückwand, 30 verlaufende Seite des Deckels 12, welche zur Rückwand 30 gerichtet ist, ist von der Rückwand 30 beabstandet. Dadurch ist ein Spalt 34 zwischen Deckel 12 und Rückwand 30 gebildet. Durch den Spalt 34 kann warme Luft abziehen. Der Deckel 12 ist in dem zur Rückwand gerichteten Endbereich nach oben um 90 Grad umgebogen. Dadurch lässt sich eine Entlüftungsvorrichtung an oder über dem Spalt befestigen.

Das Gehäuse 10 ist nach oben hin verjüngt ausgeführt und bildet eine düsenartige Grundform. Die durch den Spalt 34 nach oben abziehende Luftströmung reißt den zur Rückwand 30 gelenkten Luftstrom durch die Öffnungen 32, welche durch die Teilbereiche 20 im Deckel 12 gebildet sind mit.

Die Verjüngung ist in der in den Figuren 1 bis 3 gezeigten Ausführungsform durch einen obere Abschnitt 18 der Frontseite 16 gebildet, welcher sich zum Deckel 12 hin in Richtung Rückwand 30 neigt. Diese Form der Frontwand 16 wird durch einfaches umbiegen erzeugt. Die Seitenwände 14 sind in dem zum Endbereich 18 korrespondierendem Abschnitt entsprechend verjüngend ausgeführt.

In dem oberen Abschnitt 18 ist ein quaderförmiges Steuerungsteil 40 mit einem Handbediengerät 42 eingelassen. Eine Front des Steuerungsteils 40 und des Handbediengerätes 42 verläuft parallel zur Rückwand, so dass das Steuerteil aus dem Gehäuse 10 hervorsteht. Dies erlaubt einen einfacheren Austausch des Steuerungsteils 40 und des Handbediengerätes 42. Das Handbediengerät 42 ist vorzugsweise lösbar am Steuerungsteil 40 befestigt insbesondere eingeklipst, wobei einmal ein Verbindungskabel einklipsbar gestaltet ist und das Handbediengerät 42 selbst auch einklipsbar gestaltet ist. Die empfindliche Elektronik des Steuerungsteils ist so aber auch von anderen Wärmequellen der elektrischen Vorrichtung besser thermisch getrennt.

## Patentansprüche

1. Gehäuse (10) mit mindestens einer Gehäusewand (14, 16, 30), welche vorzugsweise als Deckel (12), Rückwand (30), Frontwand (16), oder als eine von zwei Seitenwänden (14) ausgeführt ist, wobei das Gehäuse einen Deckel, eine Rückwand, eine Frontwand und zwei Seitenwände aufweist, wobei in der Gehäusewand ein oder mehrere Teilbereiche (20) der Gehäusewand durch jeweils eine Unterbrechung (24) der Gehäusewand entlang eines Teils einer Begrenzungslinie des Teilbereichs beziehungsweise der Teilbereiche von einem Restbereich (26) der Gehäusewand teilweise getrennt ist beziehungsweise sind, **dadurch gekennzeichnet, dass** der Teilbereich oder die mehreren Teilbereiche entlang jeweils einer Biegelinie (28) mit dem Restbereich verbunden ist beziehungsweise sind
und der Teilbereich oder die mehreren Teilbereiche entlang der jeweiligen Biegelinie so umgebogen ist beziehungsweise sind, dass der Teilbereich aus dem Gehäuse hervorsteht oder in das Gehäuse hineinragt bzw. die mehreren Teilbereiche aus dem Gehäuse hervorstehen oder in das Gehäuse hineinragen,
wobei das Gehäuse als Feld (22) bezeichenbare Gehäuseabschnitte aufweist, die jeweils mehrere Teilbereiche aufweisen,
wobei die mehreren Teilbereiche in einem jeweiligen Feld alle geometrisch gleich ausgeführt sind und entweder in das Gehäuse hineinragen oder aus dem Gehäuse hervorstehen,
wobei die mehreren Teilbereiche in einem jeweiligen Feld regelmäßig voneinander beabstandet sind, wobei sie in jeweils zwei Richtungen regelmäßig voneinander beabstandet sind,
wobei das Gehäuse (10) nach oben hin verjüngt ausgeführt ist und bildet eine düsenartige Grundform,
wobei die durch einen Spalt (34) nach oben abziehende Luftströmung reißt den zur Rückwand (30) gelenkten Luftstrom durch Öffnungen (32), welche durch die Teilbereiche (20) im Deckel (12) gebildet sind mit."

2. Gehäuse nach Anspruch 1,
**dadurch gekennzeichnet, dass**
das Gehäuse (10) ein Gehäuse eines elektrischen Geräts, insbesondere eines Umrichters, ist.

3. Gehäuse nach einem der vorherigen Ansprüche, **dadurch gekennzeichnet, dass**
der Teilbereich (20) oder die mehreren Teilbereiche eben ausgeführt ist und um einen Winkel im Bereich zwischen null und neunzig Grad, vorzugsweise zwischen fünf Grad und fünfundvierzig Grad umgebogen ist.

4. Gehäuse nach einem der vorherigen Ansprüche, **dadurch gekennzeichnet, dass**
der Teilbereich (20) oder die mehreren Teilbereiche je eine viereckige, vorzugsweise annähernd quadratische Form aufweist bzw. aufweisen und die jeweilige Biegelinie (28) einer Kante der viereckigen Form entspricht.

5. Gehäuse nach einem der vorherigen Ansprüche, **dadurch gekennzeichnet, dass**
die Unterbrechung (24) mittels Laserschneiden in die Gehäusewand eingebracht ist.

6. Gehäuse nach einem der vorherigen Ansprüche, **dadurch gekennzeichnet, dass**
die Rückwand (30) des Gehäuses frei von Teilbereichen ist.

7. Gehäuse nach einem der vorherigen Ansprüche, **dadurch gekennzeichnet, dass**
die-Teilbereiche (20) im Deckel (12) des Gehäuses (10) aus dem Gehäuse hervorstehen und die zugehörige jeweilige Biegelinie (28) auf der von der Rückwand (30) abgewandten Seite des Teilbereichs angeordnet ist, insbesondere wobei eine zur Rückwand gerichtete Kante des Deckels von der Rückwand beabstandet ist, wodurch ein Spalt (34) gebildet ist.

8. Gehäuse nach Anspruch 7, **dadurch gekennzeichnet, dass**
die Biegelinien (28) der Teilbereiche (20) des Deckels (12) parallel zur Rückwand (30) verlaufen.

9. Gehäuse nach einem der vorherigen Ansprüche, **dadurch gekennzeichnet, dass**
in einer der zwei Seitenwände (14) und einer Frontwand (16) des Gehäuses (10) die Biegelinien (28) der in das Gehäuse ragenden Teilbereiche in der unteren Seite des jeweilig entsprechenden Teilbereichs liegen und die Biegelinien der nach aus dem Gehäuse herausragenden Teilbereiche in der oberen Seite des jeweilig entsprechenden Teilbereichs liegen.

10. Gehäuse nach einem der vorherigen Ansprüche, **dadurch gekennzeichnet, dass**
in beiden Seitenwänden (14) des Gehäuses (10) alle Teilbereiche (20) in das Gehäuse hineinragen.

11. Gehäuse nach einem der vorherigen Ansprüche, **dadurch gekennzeichnet, dass**
ein oberer Endabschnitt der Frontwand (16) des im Wesentlichen quaderförmigen Gehäuses (10) in Richtung oben zu der Rückwand des Gehäuses geneigt ist, vorzugsweise ist dabei zwischen dem oberen Endabschnitt und einer Restfläche der Frontwand ein Winkel zwischen null und neunzig Grad gebildet.

12. Gehäuse nach Anspruch 11, **dadurch gekennzeichnet, dass**
ein Steuerungsteil (40) einer im Gehäuse (10) angeordneten elektrischen Vorrichtung aus dem oberen Endabschnitt zumindest teilweise hervorsteht, wobei insbesondere eine Bedienoberfläche des Steuerungsteils parallel zu der Rückwand (30) des Gehäuses ausgerichtet ist.

## Claims

1. Housing (10) having at least one housing wall (14, 16, 30) which is preferably designed as a top cover (12), rear wall (30), front wall (16), or as one of two side walls (14),
wherein the housing comprises a top cover, a rear wall and two side walls,
wherein in the housing wall one or more subregions (20) of the housing wall is or are partially separated from a remaining region (26) of the housing wall by in each case an interruption (24) of the housing wall along a part of a boundary line of the subregion or the subregions,
**characterised in that**
the subregion or plurality of subregions is or are connected to the remaining region along in each case a bending line (28) and the subregion or plurality of subregions is or are bent along the respective bending line such that the subregion protrudes from the housing or projects into the housing or the plurality of subregions protrude from the housing or project into the housing,
wherein the housing comprises housing sections which can be referred to as an array (22) and which each comprise a plurality of subregions,
wherein the plurality of subregions in a respective array are all designed geometrically the same and either project into the housing or protrude from the housing,
wherein the plurality of subregions in a respective array are spaced regularly from one another, wherein they are spaced regularly from one another in each case in two directions, wherein the housing (10) is designed upwardly tapered and forms a nozzle-like basic shape,
wherein the air current drawn off upwards through a gap (34) entrains the air flow, deflected to the rear wall (30), through openings (32) which are formed by the subregions (20) in the top cover (12).

2. Housing according to Claim 1,
**characterised in that**
the housing (10) is a housing of an electrical device, in particular of a converter.

3. Housing according to one of the preceding claims,
**characterised in that**
the subregion (20) or the plurality of subregions are of plane design and are bent by an angle in the range between zero and ninety degrees, preferably between five degrees and forty-five degrees.

4. Housing according to one of the preceding claims,
**characterised in that**
the subregion (20) or the plurality of subregions each has or have a quadrangular, preferably approximately square, shape and the respective bending line (28) corresponds to an edge of the quadrangular shape.

5. Housing according to one of the preceding claims,
**characterised in that**
the interruption (24) is produced in the housing wall by means of laser cutting.

6. Housing according to one of the preceding claims,
**characterised in that**
the rear wall (30) of the housing is free from subregions.

7. Housing according to one of the preceding claims,
**characterised in that**
the subregions (20) in the top cover (12) of the housing (10) protrude from the housing and the associated respective bending line (28) is arranged on the side of the subregion facing away from the rear wall (30),
in particular wherein an edge of the top cover directed towards the rear wall is spaced from the rear wall, whereby a gap (34) is formed.

8. Housing according to Claim 7,
**characterised in that**
the bending lines (28) of the subregions (20) of the top cover (12) run parallel to the rear wall (30).

9. Housing according to one of the preceding claims,
**characterised in that**
in one of the two side walls (14) and a front wall (16) of the housing (10) the bending lines (28) of the subregions projecting into the housing lie in the lower side of the respectively corresponding subregion
and the bending lines of the subregions protruding from the housing lie in the upper side of the respectively corresponding subregion.

10. Housing according to one of the preceding claims,
**characterised in that**
in both side walls (14) of the housing (10), all subregions (20) project into the housing.

11. Housing according to one of the preceding claims,
**characterised in that**
an upper end section of the front wall (16) of the substantially cuboid-shaped housing (10) is inclined in the direction upwards towards the rear wall of the housing, preferably an angle between zero and ninety degrees thereby being formed between the upper end section and a remaining area of the front wall.

12. Housing according to Claim 11,
**characterised in that**
a control part (40) of an electrical apparatus arranged in the housing (10) protrudes at least partially from the upper end section,
wherein in particular an operating surface of the control part is oriented parallel to the rear wall (30) of the housing.

## Revendications

1. Boîtier (10), avec au moins une paroi de boîtier (14, 16, 30) qui est de préférence réalisée sous forme de couvercle (12), de paroi arrière (30), de paroi avant (16) ou de l'une de deux parois latérales (14),
sachant que le boîtier présente un couvercle, une paroi arrière, une paroi avant et deux parois latérales,
sachant que, dans la paroi de boîtier, une ou plusieurs régions partielles (20) de la paroi de boîtier est ou sont séparées, par une interruption respective (24) de la paroi de boîtier le long d'une partie d'une ligne de délimitation de la région partielle ou des régions partielles, d'une région restante (26) de la paroi de boîtier,
**caractérisé en ce que** la région partielle ou les régions partielles est ou sont reliées à la région restante le long d'une ligne de flexion respective (28),
et la région partielle ou les régions partielles est ou sont recourbées le long de la ligne de flexion respective de telle sorte que la région partielle ou les régions partielles fait/font saillie par rapport au boîtier ou pénètre/pénètrent dans le boîtier,
sachant que le boîtier présente des parties de boîtier pouvant être qualifiées de champs (22), qui présentent chacune plusieurs régions partielles,
sachant que les régions partielles d'un champ respectif sont toutes réalisées géométriquement identiques et soit pénètrent dans le boîtier, soit font saillie par rapport au boîtier,
sachant que les régions partielles d'un champ respectif sont régulièrement espacées les unes des autres, sachant qu'elles sont régulièrement espacées les unes des autres chaque fois dans deux directions,
sachant que le boîtier (10) est réalisé rétréci vers le haut et présente une forme de base du genre buse,
sachant que le flux d'air s'évacuant vers le haut par une fente (34) entraîne avec lui, par des ouvertures (32) qui sont formées par les régions partielles (20) dans le couvercle (12), le courant d'air dirigé vers la paroi arrière (30).

2. Boîtier selon la revendication 1, **caractérisé en ce que** le boîtier (10) est le boîtier d'un appareil électrique, en particulier d'un convertisseur.

3. Boîtier selon l'une des revendications précédentes, **caractérisé en ce que** la région partielle (20) ou les régions partielles sont réalisées planes et sont recourbées sous un angle compris entre zéro et quatre-vingt-dix degrés, de préférence entre cinq degrés et quarante-cinq degrés.

4. Boîtier selon l'une des revendications précédentes, **caractérisé en ce que** la région partielle (20) ou les régions partielles présentent chacune une forme quadrangulaire, de préférence approximativement carrée, et la ligne de flexion respective (28) correspond à un côté de la forme quadrangulaire.

5. Boîtier selon l'une des revendications précédentes, **caractérisé en ce que** l'interruption (24) est pratiquée dans la paroi de boîtier par découpage au laser.

6. Boîtier selon l'une des revendications précédentes, **caractérisé en ce que** la paroi arrière (30) du boîtier est dépourvue de régions partielles.

7. Boîtier selon l'une des revendications précédentes, **caractérisé en ce que** les régions partielles (20) dans le couvercle (12) du boîtier (10) font saillie par rapport au boîtier, et la ligne de flexion respective associée (28) est disposée sur le côté de la région partielle qui est éloigné de la paroi arrière (30),
sachant notamment qu'un côté, dirigé vers la paroi arrière, du couvercle est distant de la paroi arrière, de sorte qu'une fente (34) est formée.

8. Boîtier selon la revendication 7, **caractérisé en ce que** les lignes de flexion (28) des régions partielles (20) du couvercle (12) s'étendent parallèlement à la paroi arrière (30).

9. Boîtier selon l'une des revendications précédentes, **caractérisé en ce que**, dans une des deux parois latérales (14) et dans une paroi avant (16) du boîtier (10), les lignes de flexion (28) des régions partielles pénétrant dans le boîtier se situent dans le côté inférieur de la région partielle correspondante respective,
et les lignes de flexion des régions partielles faisant saillie par rapport au boîtier se situent dans le côté supérieur de la région partielle correspondante respective.

10. Boîtier selon l'une des revendications précédentes, **caractérisé en ce que**, dans les deux parois latérales (14) du boîtier (10), toutes les régions partielles (20) pénètrent dans le boîtier.

11. Boîtier selon l'une des revendications précédentes, **caractérisé en ce qu'**une partie terminale supérieure de la paroi avant (16) du boîtier (10) essentiellement parallélépipédique est inclinée vers le haut en direction de la paroi arrière du boîtier et, de préférence, un angle compris entre zéro et quatre-vingt-dix degrés est alors formé entre la partie terminale supérieure et une surface restante de la paroi avant.

12. Boîtier selon la revendication 11, **caractérisé en ce qu'**un élément de commande (40) d'un dispositif électrique disposé dans le boîtier (10) fait saillie au moins partiellement par rapport à la partie terminale supérieure,
sachant notamment qu'une interface utilisateur de l'élément de commande est orientée parallèlement à la paroi arrière (30) du boîtier.
